# EUROPÄISCHE PATENTSCHRIFT

(11) **EP 3 858 924 B1**
(45) Veröffentlichungstag und Bekanntmachung des Hinweises auf die Patenterteilung: **31.08.2022**
(21) Anmeldenummer: 20212065.5
(22) Anmeldetag: 04.12.2020
(51) Int. Cl.: C09D 5/24, G06F 3/044, H01B 1/20, H05K 3/02, C08L 67/00, G06F 3/041, H01B 1/22, H05K 3/12, C08L 33/08, H05K 1/09

(54) **ELEKTRISCH LEITFÄHIGER LASERBARER LACK, VERFAHREN ZU DESSEN HERSTELLUNG SOWIE VERWENDUNG DES LACKES ZUR HERSTELLUNG EINES TOUCH-BEDIENELEMENTES**
ELECTRICALLY CONDUCTIVE LASER-ENGRAVABLE VARNISH, METHOD FOR ITS PRODUCTION AND USE OF THE VARNISH FOR PRODUCING A TOUCH CONTROL ELEMENT
PEINTURE ÉLECTROCONDUCTRICE LASER, SON PROCÉDÉ DE FABRICATION AINSI QU'UTILISATION DE LA PEINTURE POUR FABRIQUER UN ÉLÉMENT TACTILE DE COMMANDE

(30) Priorität: 29.01.2020 DE 102020102094
(43) Veröffentlichungstag der Anmeldung: 04.08.2021
(73) Patentinhaber: Nordwest-Chemie GmbH, 30179 Hannover (DE)
(72) Erfinder: Iwanetzki, Jörg, 30179 Hannover (DE); Schulze, Detlev, 30179 Hannover (DE)
(74) Vertreter: Sandvoß, Stefanie

(56) Entgegenhaltungen:
- WO-A1-2014/013899
- WO-A1-2017/014236
- WO-A2-2007/022226
- JP-A- S60 255 861
- JP-A- 2016 071 172

## Beschreibung

Die vorliegende Erfindung betrifft einen elektrisch leitfähigen laserbaren Lack, ein Verfahren zu dessen Herstellung sowie die Verwendung des Lackes zur Herstellung eines Touch-Bedienelementes, z.B. eines Schalters.

Heutzutage ist es nicht mehr erforderlich, zur Bedienung eines elektronischen Bauteiles mit verschiedenen Funktionen den Überblick über eine Vielzahl von klassischen durch Drücken zu betätigenden Bedienelementen wie Schaltern, Tasten und Knöpfen zu behalten und diese in Abhängigkeit der gewünschten Funktion zu betätigen. Dies wäre auch viel zu umständlich in unserer Zeit des technischen Fortschritts, in der alle Geräte immer mehr können sollen und dementsprechend für ein größeres Angebot an Funktionen auch immer mehr Bedienelemente benötigt würden.

Neben der fehlenden Übersichtlichkeit bei einer Vielzahl von Schaltern weisen diese überdies den Nachteil einer weniger ansprechenden Optik auf, da Geräte bzw. Bedienoberflächen mit weniger Schaltern, Tasten und Knöpfen vom Benutzer oftmals als ästhetischer empfunden werden. Dementsprechend geht der Trend also in vielen Bereichen bereits seit längerer Zeit zu einer scheinbar schalterlosen Touch-Bedienoberfläche, so beispielsweise bei Mobiltelefonen, Küchengeräten und im Innenraum von Autos.

Es ist bekannt, Touch-Bedienelemente, z.B. für den Automobilbereich, im sog. IML-Verfahren (In-mould-labeling-Verfahren) herzustellen. Dabei werden Kunststofffolien verwendet, auf die zu durchleuchtende Symbole im Druckverfahren aufgebracht werden. Anschließend werden die Folien z.B. im Spritzgussverfahren mit Kunststoff über- oder hinterspritzt, um eine gewünschte Bauteilgeometrie zu erzeugen, wobei als Kunststoff insbesondere transparente Kunststoffe eingesetzt werden, z.B. Polycarbonat (PC) oder (Polymethylmethacrylat (PMMA).

Alternativ dazu und überdies kostengünstiger sowie auch für geringere Stückzahlen geeignet, ist auch die Herstellung der Bauteile aus transparentem Kunststoff, z.B. aus PC oder PMMA, im klassischen Spritzgussverfahren möglich.

Im Anschluss an das IML-Verfahren oder Spritzgussverfahren wird ein lichtdichter Lack innen oder außen im Spritzverfahren oder Druckverfahren auf den Kunststoff aufgebracht. Die für die spätere Anwendung zu durchleuchtenden Symbole werden nachträglich durch einen Laserprozess erzeugt.

Zur Erzeugung elektrisch leitfähiger Strukturen können Metalldrähte oder -bahnen, z.B. Kupferbahnen, auf die Folienoberfläche aufgebracht, insbesondere geklebt werden, wodurch konduktiv ausgerüstete Folien auf der Innenseite der Bauteile erhalten werden und durch Stromfluss ein elektromagnetisches Feld auf der Oberfläche der Bauteile erzeugt werden kann. Durch die Annäherung eines leitenden Objektes, insbesondere eines Fingers einer menschlichen Hand, an die als kapazitive Sensoren fungierenden leitfähigen Strukturen wird die daraus resultierende Veränderung des Kraftfeldes von diesen erfasst, woraufhin sie mit einer Spannungsänderung reagieren, die als Funktionsauslöser genutzt werden kann.

Obwohl diese Art von Touch-Bedienelementen für den Benutzer äußerst komfortabel und überdies auch optisch ansprechend ist, bringen sie doch den Nachteil mit sich, dass für jede gewünschte Anwendung eine eigene Folie konzipiert und in Serie hergestellt sowie mit dem Kunststoff verbunden werden muss, was einen immensen zeitlichen und finanziellen Aufwand erfordert.

Es wäre daher wünschenswert, auf das Anbringen einer Folie oder eines PCB auf den Bauteilen bzw. Substraten, insbesondere auf Kunststoffformteilen verzichten zu können und die Oberfläche der Kunststoffformteile auf andere Weise als Schalter zu gestalten. Durch einen herkömmlichen Lack ist dieses jedoch nicht möglich. Denn es gibt auf der einen Seite zwar Leitlacke, die jedoch nicht laserbar sind, und auf der anderen Seite Laserlacke, die jedoch nicht elektrisch leitfähig sind. Sowohl ein Lackieren von Kunststoffteilen mit einem herkömmlichen Leitlack als auch das Lackieren der Kunststoffteile mit einem herkömmlichen Laserlack wäre daher nicht zielführend und könnte zu keinem lackierten Kunststoffformteil führen, das gleichzeitig als Touch-Bedienelement fungieren könnte.

Die WO 2018/213161 A1 beschreibt eine dielektrische Tinten-Zusammensetzung, die z.B. auf Leiterplatten aufgetragen werden kann und für Touch-Anwendungen geeignet sein soll. Die Zusammensetzung kann Polyesterharz, Lösungsmittel, Celluloseester, Leitpigmente und Netzmittel enthalten. Die Zusammensetzung stellt jedoch keinen Lack dar und enthält auch kein Magnesiumsilikathydrat und kein Acrylatharz.

Die US 2009/0258241 A1 beschreibt ein Verfahren zur Beschichtung eines Substrates mit einem leitfähigen Film. Zur Herstellung des leitfähigen Films wird ein leitfähiges Material, das mit einem Schutzmaterial bedeckt ist, mit einem Material kontaktiert, das Anionenaustauschfähigkeit aufweist. Es wird eine Zusammensetzung beschrieben, die Leitpigmente, Polyesterharz, Lösungsmittel, Acrylatharz, Magnesiumsilikat und Netzmittel enthält bzw. enthalten kann, jedoch keinen Celluloseester bzw. keine Celluloseester-Lösung.

Die WO 2014/013899 A1 beschreibt gemäß der englischsprachigen Computerübersetzung eine laserbare Paste, die ein Bindemittelharz enthält, das wiederum ein thermoplastisches Harz, ein Metallpulver sowie ein organisches Lösemittel und optional Talkum enthält. Das Bindemittelharz kann ein Polyesterharz oder ein Polyurethanharz sein. Aus der Paste, die elektrisch leitfähig sein soll, kann ein leitfähiger dünner Film hergestellt werden.

Die WO 2017/014236 A1 beschreibt gemäß der englischsprachigen Computerübersetzung ebenfalls eine laserbare Paste, die ein Bindemittelharz, ein Metallpulver sowie ein organisches Lösemittel enthält, wobei die Partikel der Paste einen mittleren Durchmesser von bis zu 20 µm aufweisen.

Die WO 2007/022226 A2 beschreibt einen transparenten Leiter, der ein Substrat und eine auf diesem angeordnete leitfähige Schicht umfasst, die eine Vielzahl an Metall-Nanodrähten enthält.

Die JP 2016 0711 72 A beschreibt eine lichtempfindliche, leitfähige Paste, die ein lichtempfindliches, organisches Bindemittel, ein leitfähiges Pulver, eine photopolymerisierbare Verbindung, einen Fotoinitiator und ein organisches Lösemittel enthält.

Die JP S60 255861 beschreibt eine widerstandsfähige Beschichtungszusammensetzung, die u.a. ein Acryl-Polyol und eine Polyisocyanatverbindung enthält.

### Aufgabe der Erfindung

Es ist daher die Aufgabe der vorliegenden Erfindung, eine alternative Möglichkeit für ein Touch-Bedienelement bereitzustellen, das die o.g. aus dem Stand der Technik bekannten Nachteile vermeidet und insbesondere einen Lack bereitzustellen, der zum Lackieren von Substraten, insbesondere von Kunststoffformteilen oder Glas, verwendet werden kann, wobei der Lack nach dem Einbringen von Leiterbahnen in dessen Oberfläche als Schalter fungieren kann.

Eine weitere Aufgabe der vorliegenden Erfindung ist es darüber hinaus, ein Touch-Bedienelement bereitzustellen, das auf die o.g. aus dem Stand der Technik bekannte Folie bzw. auf den o.g. aus dem Stand der Technik bekannten PCB verzichtet.

### Allgemeine Beschreibung der Erfindung

Die Erfindung löst diese Aufgabe mit den Merkmalen der Ansprüche und insbesondere durch Bereitstellen eines elektrisch leitfähigen laserbaren Lackes, der
- 3-8 Gew.-% Celluloseester-Lösung mit einem Gehalt an Celluloseester in der Lösung von 2-10 Gew.-%;
- 2-10 Gew.-% eines Leitpigments;
- 5-20 Gew.-% Polyesterharz;
- 5-20 Gew.-% Acrylatharz;
- 0,5-10 Gew.-% pulverförmiges Magnesiumsilikathydrat;
- zumindest ein Netzmittel; und
- zumindest ein Lösungsmittel umfasst oder daraus besteht.

Der erfindungsgemäße Lack kann ein Ein-Komponenten-Lack oder alternativ ein Zwei-Komponenten-Lack sein. In Ausführungsformen, in denen der Lack als Zwei-Komponenten-Lack ausgebildet ist, sind die o.g. Inhaltsstoffe die Bestandteile des sog. Stammlacks (der ersten Komponente), während der Lack als zusätzlichen Inhaltsstoff einen Härter (die zweite Komponente) enthält. Bevorzugt enthält der Härter dabei mindestens zwei Isocyanat-Funktionalitäten, insbesondere zwei oder drei Isocyanat-Funktionalitäten.

Unter einem laserbaren Lack wird für die Zwecke der Erfindung ein Lack verstanden, der sich gut mit einem Laser bearbeiten lässt, d.h. der insbesondere einen rückstandsfreien Abtrag erlaubt und bei Abtrag der Deckschicht eine hohe Konturenschärfe verleiht. Weiterhin muss der Laserlack über eine hohe Temperatur- und Farbbeständigkeit der darunter liegenden Lackschichten verfügen und in geringer Schichtdicke von bereits 25-30 µm eine hohe Lichtdichtigkeit besitzen, sodass Licht nur durch die freigelaserte Symbolik fällt.

Unter einem Leitpigment wird ein elektrisch leitfähiges Pigment verstanden. Das in dem erfindungsgemäßen Lack enthaltene Leitpigment ist bevorzugt aus der Gruppe ausgewählt, die Ruß, Graphit, Silber sowie silberbedampfte Substrate, insbesondere mit Silber bedampftes Glas oder mit Silber bedampftes Kupfer, und Kombinationen dieser umfasst oder daraus besteht. Alternativ oder zusätzlich dazu können auch ein oder mehrere leitend beschichtete, mineralische Pigmente als Leitpigment in dem Lack enthalten sein.

Der Gewichtsanteil an Leitpigment in dem erfindungsgemäßen Lack beträgt 2,0-10,0 Gew.%, bevorzugter 2,5-8,0 Gew.-% und besonders bevorzugt 3,0-6,0 Gew.-%.

Bei der in dem erfindungsgemäßen Lack enthaltenen Celluloseester-Lösung handelt es sich bevorzugt um eine Lösung von Celluloseacetat, Cellulosebutyrat und/oder Celluloseacetatbutyrat, wobei das Lösungsmittel optional ein Acetat ist oder dieses umfasst. Der Gewichtsanteil an Celluloseester in der Lösung beträgt dabei erfindungsgemäß 2,0-10,0 Gew.-%, insbesondere 3,0-8,0 Gew.-%, bevorzugter 3,5-7,0 Gew.-% und besonders bevorzugt 4,0-6,0 Gew.-%. Der Gewichtsanteil an Celluloseester-Lösung in dem erfindungsgemäßen Lack beträgt 3,0-8,0 Gew.-%, bevorzugter 3,5-7,0 Gew.-% und besonders bevorzugt 4,0-6,0 Gew.-%.

Der erfindungsgemäße Lack enthält weiterhin 5-20 Gew.-% Polyesterharz, wobei unter Polyesterharzen gemäß der allgemeinen Definition Kondensationsprodukte von mehrwertigen Alkoholen und Dicarbonsäuren verstanden werden. Das in dem erfindungsgegenständlichen Lack enthaltene Polyesterharz ist bevorzugt ein aus verschiedenen mehrwertigen Alkoholen und/oder verschiedenen Dicarbonsäuren erhaltenes Kondensationsprodukt und demnach ein Copolymer bzw. insbesondere eine Mischung von Copolymeren mit unterschiedlichen Kettenlängen.

Der Gewichtsanteil an Polyesterharz in dem erfindungsgemäßen Lack beträgt 5,0-20,0 Gew.-%, bevorzugter 8,0-18,0 Gew.-% und besonders bevorzugt 11,0-16,0 Gew.-%.

Weiterhin enthält der erfindungsgemäße elektrisch leitfähige und laserbare Lack auch 5-20 Gew.-% Acrylatharz. Unter einem Acrylatharz werden Polymere oder Copolymere der Acrylsäure, Methacrylsäure oder deren Estern, insbesondere mit anderen ungesättigten Monomeren wie z.B. Styrol oder Acrylnitril verstanden. Insbesondere handelt es sich bei dem in dem erfindungsgemäßen Lack enthaltenen Acrylatharz um ein polyisocyanatvernetzendes Acrylatharz, d.h. um ein Acrylatharz, das in der Lage ist, Polyisocyanat zu vernetzen.

Der Gewichtsanteil an Acrylatharz in dem erfindungsgemäßen Lack beträgt 5,0-20,0 Gew.%, bevorzugter 8,0-18,0 Gew.-% und besonders bevorzugt 11,0-16,0 Gew.-%.

Der erfindungsgemäße Lack enthält auch 0,5-10 Gew.-% pulverförmiges Magnesiumsilikathydrat, auch bekannt unter der Bezeichnung "Talkum". Der Gewichtsanteil an pulverförmigem Magnesiumsilikathydrat in dem erfindungsgemäßen Lack beträgt 0,5-10,0 Gew.-%, bevorzugter 1,0-8,0 Gew.-% und besonders bevorzugt 1,5-7,0 Gew.-%.

Weiterhin enthält der erfindungsgemäße Lack auch zumindest ein Netzmittel, d.h. zumindest eine Verbindung, die die Oberflächenspannung des Lackes oder einzelner seiner Bestandteile herabsetzt. Bei dem zumindest einen Netzmittel handelt es sich bevorzugt um ein Netzmittel zur Pigmentbenetzung, das unabhängig davon bevorzugt aus der Gruppe ausgewählt ist, die Alkylsulfate, Alkylsulfonate und Polyglykolether umfasst oder daraus besteht.

Gemäß einer bevorzugten Ausführungsform enthält der erfindungsgemäße Lack zumindest zwei Netzmittel, wobei das erste Netzmittel aus der Gruppe ausgewählt ist, die Alkylsulfate, Alkylsulfonate und Polyglykolether umfasst oder daraus besteht, und das zweite Netzmittel ein nicht-ionisches Netzmittel ist. Gemäß dieser Ausführungsform ist der Anteil des ersten Netzmittels in dem erfindungsgemäßen Lack vorzugsweise größer als der Anteil des zweiten Netzmittels, insbesondere um mindestens den Faktor 2.

Der Gesamtanteil an Netzmittel in dem erfindungsgemäßen Lack beträgt bevorzugt 2,0-10,0 Gew.-%, bevorzugter 2,5-8,0 Gew.-% und besonders bevorzugt 3,0-7,0 Gew.-%.

Weiterhin enthält der erfindungsgemäße Lack auch zumindest ein Lösungsmittel, wobei der Lack gemäß einer bevorzugten Ausführungsform zumindest zwei verschiedene Lösungsmittel enthält, die unabhängig voneinander aus der Gruppe ausgewählt sind, die Acetate, Ketone und aliphatische Lösungsmittel, jeweils im Siedebereich bis max. 200 °C, umfasst oder daraus besteht.

Der Gesamtanteil an Lösungsmittel in dem erfindungsgemäßen Lack beträgt bevorzugt 25,0-65,0 Gew.-%, bevorzugter 30,0-60,0 Gew.-% und besonders bevorzugt 35,0-55,0 Gew.-%.

Die Erfindung betrifft auch ein Verfahren zur Herstellung eines elektrisch leitfähigen laserbaren Lackes, der
- 3-8 Gew.-% Celluloseester-Lösung mit einem Gehalt an Celluloseester in der Lösung von 2,0-10,0 Gew.-%, insbesondere 3,0-8,0 Gew.-%, bevorzugter 3,5-7,0 Gew.-% und besonders bevorzugt 4,0-6,0 Gew.-%.;
- 2-10 Gew.-% eines Leitpigments;
- 5-20 Gew.-% Polyesterharz;
- 5-20 Gew.-% Acrylatharz;
- 0,5-10 Gew.-% pulverförmiges Magnesiumsilikathydrat;
- zumindest ein Netzmittel; und
- zumindest ein Lösungsmittel umfasst oder daraus besteht.

Das erfindungsgemäße Verfahren zur Herstellung des elektrisch leitfähigen laserbaren Lackes umfasst die folgenden Schritte:
- Vorlegen des Polyesterharzes und des Acrylatharzes in einem Lösungsmittel;
- Zugabe von Leitpigment und pulverförmigem Magnesiumsilikathydrat;
- Dispergieren bis zum Erhalt einer homogenen Mischung;
- Mahlen der homogenen Mischung, insbesondere in einer Perlmühle.

In Ausführungsformen, in denen der erfindungsgemäße Lack als Zwei-Komponenten-Lack hergestellt wird, umfasst das Verfahren einen zusätzlichen Schritt der Zugabe eines Härters zu den Inhaltsstoffen des sog. Stammlacks, insbesondere eines Isocyanat-haltigen Härters mit vorzugsweise zwei oder drei Isocyanat-Funktionalitäten. Dieser Schritt erfolgt nach den vorgenannten Schritten des erfindungsgemäßen Verfahrens.

In Bezug auf das erfindungsgemäße Verfahren zur Herstellung des elektrisch leitfähigen laserbaren Lackes sind alle zur Herstellung des Lackes verwendeten Inhaltsstoffe so definiert wie im Voranstehenden mit Bezug auf den Lack als solchen beschrieben. D.h. insbesondere:
- dass das in dem erfindungsgemäßen Verfahren zur Herstellung des Lackes eingesetzte Leitpigment bevorzugt aus der Gruppe ausgewählt, die Ruß, Graphit, Silber sowie silberbedampfte Substrate, insbesondere mit Silber bedampftes Glas oder mit Silber bedampftes Kupfer, und Kombinationen dieser umfasst oder daraus besteht und/oder dass das Leitpigment ein leitend beschichtetes, mineralisches Pigment enthält oder daraus besteht;
- dass die in dem erfindungsgemäßen Verfahren zur Herstellung des Lackes eingesetzte Celluloseester-Lösung bevorzugt eine Lösung von Celluloseacetat, Cellulosebutyrat und/oder Celluloseacetatbutyrat ist, wobei das Lösungsmittel optional ein Acetat ist oder dieses umfasst;
- dass das in dem erfindungsgemäßen Verfahren zur Herstellung des Lackes eingesetzte Polyesterharz bevorzugt ein aus verschiedenen mehrwertigen Alkoholen und/oder verschiedenen Dicarbonsäuren erhaltenes Kondensationsprodukt ist und demnach bevorzugt ein Copolymer bzw. insbesondere eine Mischung von Copolymeren mit unterschiedlichen Kettenlängen ist;
- dass das in dem erfindungsgemäßen Verfahren zur Herstellung des Lackes eingesetzte Acrylatharz bevorzugt ein polyisocyanatvernetzendes Acrylatharz ist;
- dass das in dem erfindungsgemäßen Verfahren zur Herstellung des Lackes eingesetzte zumindest eine Netzmittel bevorzugt ein Netzmittel zur Pigmentbenetzung ist, das unabhängig davon bevorzugt aus der Gruppe ausgewählt ist, die Alkylsulfate, Alkylsulfonate und Polyglykolether umfasst oder daraus besteht; wobei bevorzugt zwei unterschiedliche Netzmittel eingesetzt werden, von denen das erste Netzmittel aus der Gruppe ausgewählt ist, die Alkylsulfate, Alkylsulfonate und Polyglykolether umfasst oder daraus besteht, und das zweite Netzmittel ein nicht-ionisches Netzmittel ist;
   und wobei der Gewichtsanteil des ersten Netzmittels vorzugsweise größer als der Gewichtsanteil des zweiten Netzmittels ist, insbesondere um mindestens den Faktor 2;
- dass das in dem erfindungsgemäßen Verfahren zur Herstellung des Lackes eingesetzte zumindest eine Lösungsmittel bevorzugt aus der Gruppe ausgewählt ist, die Acetate, Ketone und aliphatische Lösungsmittel, jeweils im Siedebereich bis max. 200 °C, umfasst oder daraus besteht;
wobei bevorzugt zwei unterschiedliche Lösungsmittel eingesetzt werden, die unabhängig voneinander aus der Gruppe ausgewählt sind, die Acetate, Ketone und aliphatische Lösungsmittel, jeweils im Siedebereich bis max. 200 °C, umfasst oder daraus besteht.

Die bevorzugten Gewichtsanteile, in denen die verschiedenen Inhaltsstoffe in dem erfindungsgemäßen Verfahren eingesetzt werden, sind identisch zu den mit Bezug auf den erfindungsgemäßen Lack als solchen beschriebenen bevorzugten Gewichtsanteilen.

In dem erfindungsgemäßen Verfahren zur Herstellung des elektrisch leitfähigen laserbaren Lackes werden zunächst das Polyesterharz und das Acrylatharz in einem Lösungsmittel vorgelegt. Dann werden das Leitpigment und das pulverförmige Magnesiumsilikathydrat zugegeben und es wird bis zum Erhalt einer homogenen Mischung dispergiert. Die homogene Mischung wird anschließend bevorzugt in einer Perlmühle gemahlen, wobei die Mahlung vorzugsweise unter Kühlung und mit einer Perlgröße < 1,5 mm, insbesondere mit einer Perlgröße ≤ 1,3 mm, erfolgt. Durch das Mahlen wird eine Mischung erhalten, deren Korngröße kleiner ist als die Korngröße des eingesetzten Leitpigmentes. Insbesondere beträgt die Korngröße der durch das Mahlen erhaltenen Mischung < 50 µm, < 40 µm, < 30 µm, < 20 µm oder < 10 µm.

Nach dem Mahlen wird die dadurch erhaltene Mischung noch mit dem zumindest einen Netzmittel sowie optional weiterem Lösungsmittel versetzt und durch Dispergieren, bevorzugt bei Raumtemperatur, wird der erfindungsgemäße Lack erhalten.

Die Erfindung betrifft auch die Verwendung des erfindungsgemäßen elektrisch leitfähigen und laserbaren Lackes zur Herstellung eines Touch-Bedienelementes.

Unter einem Touch-Bedienelement wird für die Zwecke der Erfindung ein insbesondere berührungsempfindliches Element verstanden, bei dem die Annäherung eines leitenden Objektes, insbesondere eines Fingers einer menschlichen Hand, eine messbare Veränderung eines Kraft- bzw. Magnetfeldes bewirkt, was als Funktionsauslöser verwendet wird. Bevorzugte Touch-Bedienelemente sind Schalter, Tasten und Knöpfe.

Die Herstellung des Touch-Bedienelementes umfasst die Schritte:
- Bereitstellen eines erfindungsgemäßen elektrisch leitfähigen und laserbaren Lackes;
- Applizieren des Lackes auf ein Substrat, wobei das Substrat insbesondere ausgewählt ist aus der Gruppe, die Kunststoff, Glas und Holz umfasst oder daraus besteht;
- Einbringen von Leiterbahnen in die lackierte Substratoberfläche, wobei das Einbringen der Leiterbahnen beispielsweise mittels Fräsens, Markierens, Gravierens oder insbesondere mittels Lasergravierens erfolgen kann;
- Verbinden der Leiterbahnen mit einer gewünschten Elektronik.

Dementsprechend betrifft die Erfindung auch ein Touch-Bedienelement, beispielsweise einen Schalter, eine Taste oder einen Knopf, das ein mit einem erfindungsgemäßen Lack lackiertes Substrat umfasst, wobei in die lackierte Oberfläche Leiterbahnen eingebracht sind und diese mit einer gewünschten Elektronik verbunden sind. Bei dem Substrat handelt es sich vorzugsweise um Kunststoff, Glas oder Holz.

Dadurch, dass der erfindungsgemäße Lack laserbar ist, können auch noch nach dessen Aufbringen auf das Substrat und dem Einfügen von Leiterbahnen in die Substratoberfläche optische Besonderheiten, z.B. Symbole, in den Lack eingebracht werden. Alternativ oder zusätzlich dazu kann der Lack auch noch mit einem anderen Lack überlackiert werden, sofern dies aus optischen oder anderen Gründen wünschenswert oder erforderlich ist. Gemäß einer bevorzugten Ausführungsform umfasst das erfindungsgemäße Touch-Bedienelement ein Substrat, das nicht nur mit dem erfindungsgemäßen Lack, sondern noch mit zwei weiteren Lacken lackiert ist. Diese zusätzlichen Lackschichten beeinflussen jedoch nicht die Funktion des Touch-Bedienelementes, sondern wirken sich nur vorteilhaft auf dessen Optik aus. In dieser Ausführungsform weist die Substratoberfläche zunächst eine Schicht aus einem lichtdichten, z.B. schwarzen, Lack auf. Auf dieser ersten lichtdichten Lackschicht befindet sich eine zweite Lackschicht in einem hellen Kontrastfarbton, z.B. beige, und erst auf dieser zweiten Lackschicht befindet sich der laserbare elektrisch leitfähige Lack, der z.B. im Spritzverfahren oder Druckverfahren aufgebracht wird.

Der zur Herstellung bzw. Lackierung des Touch-Bedienelementes verwendete Lack weist die gleiche Zusammensetzung auf wie im Voranstehenden mit Bezug auf den Lack als solchen beschrieben. D.h. insbesondere:
- dass das in dem Lack enthaltene Leitpigment bevorzugt aus der Gruppe ausgewählt ist, die Ruß, Graphit, Silber sowie silberbedampfte Substrate, insbesondere mit Silber bedampftes Glas oder mit Silber bedampftes Kupfer, und Kombinationen dieser umfasst oder daraus besteht und/oder dass das Leitpigment ein leitend beschichtetes, mineralisches Pigment enthält oder daraus besteht;
- dass die in dem Lack enthaltene Celluloseester-Lösung einen Gehalt an Celluloseester von 2,0-10,0 Gew.-% aufweist und bevorzugt eine Lösung von Celluloseacetat, Cellulosebutyrat und/oder Celluloseacetatbutyrat ist, wobei das Lösungsmittel optional ein Acetat ist oder dieses umfasst;
- dass das in dem Lack enthaltene Polyesterharz bevorzugt ein aus verschiedenen mehrwertigen Alkoholen und/oder verschiedenen Dicarbonsäuren erhaltenes Kondensationsprodukt ist und demnach bevorzugt ein Copolymer bzw. insbesondere eine Mischung von Copolymeren mit unterschiedlichen Kettenlängen ist;
- dass das in dem Lack enthaltene Acrylatharz bevorzugt ein polyisocyanatvernetzendes Acrylatharz ist;
- dass das in dem Lack enthaltene zumindest eine Netzmittel bevorzugt ein Netzmittel zur Pigmentbenetzung ist, das unabhängig davon bevorzugt aus der Gruppe ausgewählt ist, die Alkylsulfate, Alkylsulfonate und Polyglykolether umfasst oder daraus besteht;
   wobei bevorzugt zwei unterschiedliche Netzmittel in dem Lack enthalten sind, von denen das erste Netzmittel aus der Gruppe ausgewählt ist, die Alkylsulfate, Alkylsulfonate und Polyglykolether umfasst oder daraus besteht, und das zweite Netzmittel ein nicht-ionisches Netzmittel ist;
   und wobei der Gewichtsanteil des ersten Netzmittels vorzugsweise größer als der Gewichtsanteil des zweiten Netzmittels ist, insbesondere um mindestens den Faktor 2;
- dass das in dem Lack enthaltene zumindest eine Lösungsmittel bevorzugt aus der Gruppe ausgewählt ist, die Acetate, Ketone und aliphatische Lösungsmittel, jeweils im Siedebereich bis max. 200 °C, umfasst oder daraus besteht;
wobei bevorzugt zwei unterschiedliche Lösungsmittel eingesetzt werden, die unabhängig voneinander aus der Gruppe ausgewählt sind, die Acetate, Ketone und aliphatische Lösungsmittel, jeweils im Siedebereich bis max. 200 °C, umfasst oder daraus besteht.

In der bevorzugten Ausführungsform des erfindungsgemäßen Touch-Bedienelementes, in der ein Substrat mit einer ersten lichtdichten Lackschicht, einer zweiten Lackschicht in Kontrastfarbe und einer dritten Lackschicht aus dem erfindungsgemäßen Lack lackiert ist, wurde bevorzugt durch alle drei Lackschichten gelasert, um die Symbole, die für die spätere Anwendung, insbesondere im Automobilbereich, durchleuchtet werden sollen, zu erzeugen. Die erste Lackschicht erfüllt dabei die Aufgabe, die Lichtdichtigkeit zu erzeugen, während die helle Kontrastfarbe der zweiten Lackschicht dazu dient, einen Kontrast zwischen der darunterliegenden ersten Lackschicht und der darüberliegenden dritten Lackschicht zu erzeugen.

Bei der Herstellung des Touch-Bedienelementes erfolgt vor oder nach dem Aufbringen der optional drei Lackschichten und dem Laserprozess durch die aufgebrachten Lackschichten das Erzeugen von Leiterbahnen mittels Laserns ausschließlich der dritten Lackschicht, die aus dem erfindungsgemäßen elektrisch leitfähigen, laserbaren Lack besteht.

Nach dem Einbringen der Leiterbahnen in die Lackschicht, die aus dem erfindungsgemäßen elektrisch leitfähigen, laserbaren Lack besteht, werden diese mit Elektronik verbunden bzw. kontaktiert, um durch einen Stromfluss das elektromagnetische Feld aufzubauen.

Bevorzugt wird auch ein datenverarbeitender Chip auf die aus dem erfindungsgemäßen elektrisch leitfähigen, laserbaren Lack bestehende Lackschicht aufgebracht, z.B. aufgeklebt. Das Lackieren von Bauteilen, insbesondere von Kunststoffformteilen, mit dem erfindungsgemäßen Lack zum Zwecke der im Voranstehenden beschriebenen Herstellung von Touch-Bedienelementen weist gegenüber den vorbekannten Verfahren zur Herstellung von Touch-Bedienelementen den Vorteil auf, dass kostengünstig in großer oder kleiner Stückzahl Bauteile hergestellt werden können, da zur Erzeugung unterschiedlicher Bauteilgeometrien lediglich das Laserprogramm geändert werden muss. Weiterhin ist vorteilhaft, dass sich die durch das Lasern erzeugten Leiterbahnen unmittelbar auf dem Bauteil befinden und somit eine Verschlechterung der Signalstärke durch Lufteinschlüsse zwischen Leiterbahn und der Bauteiloberfläche ausgeschlossen ist.

Besonders geeignet sind die erfindungsgemäßen Touch-Bedienelemente zur Anwendung in der Automobilbranche, wo sie insbesondere im Innenraum von Fahrzeugen verbaut werden können. Hier zeichnen sie sich insbesondere durch eine komfortable Bedienung einer optisch scheinbar schalterlosen und daher ästhetisch ansprechenden Oberfläche aus, die dennoch keine Funktionen vermissen lässt.

## Patentansprüche

1. Elektrisch leitfähiger laserbarer Lack, umfassend
- 3-8 Gew.-% Celluloseester-Lösung, wobei der Gehalt an Celluloseester in der Lösung 2-10 Gew.-% beträgt;
- 2-10 Gew.-% eines Leitpigments;
- 5-20 Gew.-% Polyesterharz;
- 5-20 Gew.-% Acrylatharz;
- 0,5-10 Gew.-% pulverförmiges Magnesiumsilikathydrat;
- zumindest ein Netzmittel;
- zumindest ein Lösungsmittel.

2. Elektrisch leitfähiger laserbarer Lack nach Anspruch 1, **dadurch gekennzeichnet, dass** der Celluloseester aus der Gruppe ausgewählt ist, die Celluloseacetat, Cellulosebutyrat und Celluloseacetatbutyrat umfasst oder daraus besteht, wobei der Celluloseester optional in Acetat gelöst vorliegt.

3. Elektrisch leitfähiger laserbarer Lack nach einem der Ansprüche 1 oder 2, **dadurch gekennzeichnet, dass** das Leitpigment aus der Gruppe ausgewählt ist, die Ruß, Graphit, Silber sowie silberbedampfte Substrate und Kombinationen dieser umfasst oder daraus besteht, und/oder ein leitend beschichtetes, mineralisches Pigment enthält oder daraus besteht.

4. Elektrisch leitfähiger laserbarer Lack nach einem der voranstehenden Ansprüche, **dadurch gekennzeichnet, dass** das Acrylatharz ein polyisocyanatvernetzendes Acrylatharz ist.

5. Elektrisch leitfähiger laserbarer Lack nach einem der voranstehenden Ansprüche, **dadurch gekennzeichnet, dass** das zumindest eine Netzmittel ein Netzmittel zur Pigmentbenetzung ist, das aus der Gruppe ausgewählt ist, die Alkylsulfate, Alkylsulfonate und Polyglykolether umfasst oder daraus besteht.

6. Elektrisch leitfähiger laserbarer Lack nach einem der voranstehenden Ansprüche, **dadurch gekennzeichnet, dass** der Lack ein Zwei-Komponenten-Lack ist und zusätzlich einen Härter umfasst, der bevorzugt mindestens zwei Isocyanat-Funktionalitäten aufweist.

7. Touch-Bedienelement, **dadurch gekennzeichnet, dass** dieses ein mit einem Lack nach einem der voranstehenden Ansprüche lackiertes Substrat umfasst, wobei in die lackierte Oberfläche Leiterbahnen eingebracht sind.

8. Touch-Bedienelement nach Anspruch 7, wobei das Substrat Kunststoff, Glas oder Holz umfasst oder daraus besteht.

9. Verfahren zur Herstellung eines Lackes nach einem der Ansprüche 1 bis 6, umfassend die Schritte:
- Vorlegen des Polyesterharzes und des Acrylatharzes in einem Lösungsmittel;
- Zugabe von Leitpigment und pulverförmigem Magnesiumsilikathydrat;
- Dispergieren bis zum Erhalt einer homogenen Mischung;
- Mahlen der homogenen Mischung.

10. Verwendung eines Lackes nach einem der Ansprüche 1 bis 6 zur Herstellung eines Touch-Bedienelementes.

## Claims

1. Electrically conductive laserable varnish comprising
- 3-8 wt.% of cellulose ester solution, the content of cellulose ester in the solution being 2-10 wt.%;
- 2-10 wt.% of a conductive pigment;
- 5-20% wt.% polyester resin;
- 5-20 wt.% acrylate resin;
- 0.5-10 wt.% magnesium silicate hydrate in powder form;
- at least one wetting agent;
- at least one solvent.

2. Electrically conductive laserable varnish according to claim 1, **characterized in that** the cellulose ester is selected from the group comprising or consisting of cellulose acetate, cellulose butyrate and cellulose acetate butyrate, the cellulose ester optionally being dissolved in acetate.

3. Electrically conductive laserable varnish according to one of claims 1 or 2, **characterized in that** the conductive pigment is selected from the group comprising or consisting of carbon black, graphite, silver, and silvervapourised substrates and combinations thereof, and/or comprises or consists of a conductively coated mineral pigment.

4. Electrically conductive laserable varnish according to one of the preceding claims, **characterized in that** the acrylate resin is a polyisocyanatecrosslinking acrylate resin.

5. Electrically conductive laserable varnish according to one of the preceding claims, **characterized in that** the at least one wetting agent is a wetting agent for pigment wetting selected from the group comprising or consisting of alkyl sulfates, alkyl sulfonates and polyglycol ethers.

6. Electrically conductive laserable varnish according to one of the preceding claims, **characterized in that** the varnish is a two-component varnish and additionally comprises a hardener which preferably has at least two isocyanate functionalities.

7. Touch control element, **characterized in that** it comprises a substrate coated with a varnish according to one of the preceding claims, conductor tracks being introduced into the coated surface.

8. Touch control element according to claim 7, wherein the substrate comprises or consists of plastic, glass or wood.

9. Process for production of a varnish according to one of claims 1 to 6, comprising the steps of:
- placing the polyester resin and the acrylate resin in a solvent;
- adding conductive pigment and powdery magnesium silicate hydrate;
- dispersing until a homogeneous mixture is obtained;
- grinding the homogeneous mixture.

10. Use of a varnish according to one of claims 1 to 6 for the production of a touch control element.

## Revendications

1. Peinture lasérable conductrice de l'électricité, comprenant
- 3,8 % en poids de solution d'ester de cellulose, la teneur en ester de cellulose de la solution valant 2-10 % en poids :
- 2-10 % en poids d'un pigment conducteur ;
- 5-20 % en poids de résine polyester ;
- 5-20 % en poids de résine acrylate ;
- 0,5-10 % en poids de silicate de magnésium hydraté pulvérulent ;
- au moins un agent mouillant ;
- au moins un solvant.

2. Peinture lasérable conductrice de l'électricité selon la revendication 1, **caractérisée en ce que** l'ester de cellulose est choisi dans le groupe qui comprend ou consiste en l'acétate de cellulose, le butyrate de cellulose et l'acétate-butyrate de cellulose, l'ester de cellulose étant en option présent en solution dans de l'acétate.

3. Peinture lasérable conductrice de l'électricité selon l'une quelconque des revendications 1 et 2, **caractérisée en ce que** le pigment conducteur est choisi dans le groupe qui comprend ou consiste en le noir de carbone, le graphite, l'argent ainsi que des substrats à dépôt d'argent pas vaporisation et des associations de ceux-ci, et/ou contient ou consiste en un pigment minéral à enrobage conducteur.

4. Peinture lasérable conductrice de l'électricité selon l'une quelconque des revendications précédentes, **caractérisée en ce que** la résine acrylate est une résine acrylate réticulant un polyisocyanate.

5. Peinture lasérable conductrice de l'électricité selon l'une quelconque des revendications précédentes, **caractérisée en ce que** ledit au moins un agent mouillant est un agent mouillant destiné au mouillage de pigments, qui est choisi dans le groupe qui comprend ou consiste en des alkylsulfates, alkylsulfonates et polyglycoléthers.

6. Peinture lasérable conductrice de l'électricité selon l'une quelconque des revendications précédentes, **caractérisée en ce que** la peinture est une peinture bicomposant et comprend en outre un durcisseur qui comporte de préférence au moins deux fonctionnalités isocyanate.

7. Élément de commande tactile, **caractérisé en ce que** ce dernier comprend un subjectile peint avec une peinture selon l'une quelconque des revendications précédentes, des pistes conductrices étant introduites dans la surface peinte.

8. Élément de commande tactile selon la revendication 7, le subjectile comprenant ou consistant en une matière plastique, du verre ou du bois.

9. Procédé pour la production d'une peinture selon l'une quelconque des revendications 1 à 6, comprenant les étapes :
- disposition au préalable de la résine polyester et de la résine acrylate dans un solvant ;
- addition de pigment conducteur et de silicate de magnésium hydraté pulvérulent :
- dispersion jusqu'à l'obtention d'un mélange homogène ;
- broyage du mélange homogène.

10. Utilisation d'une peinture selon l'une quelconque des revendications 1 à 6 pour la fabrication d'un élément de commande tactile.
